# EUROPÄISCHE PATENTANMELDUNG

(11) **EP 2 262 096 A2**
(43) Veröffentlichungstag der Anmeldung: **15.12.2010**
(21) Anmeldenummer: 10005673.8
(22) Anmeldetag: 01.06.2010
(51) Int. Cl.: H02N 6/00, H01L 31/042, H01L 27/146

(54) **Verfahren und Vorrichtung zur Abschattungsprognose für eine Photovoltaikanlage**

(30) Priorität: 08.06.2009 DE 102009024212
(71) Anmelder: Adensis GmbH, 01129 Dresden (DE)
(72) Erfinder: Beck, Bernhard, 97332 Volkach OT Dimbach (DE)

(57) **Zusammenfassung**

Es wird ein Verfahren zur Prognose einer drohenden Abschattung einer Photovoltaikanlage durch Wolkenbildung oder Wolkenbewegung vorgestellt. Dabei wird in einer ersten Ausführungsform ein Teil des Firmaments mittels einer Fischaugenoptik (50) auf die Eingangsoptik einer Digitalkamera (56) abgebildet. Es werden Pixelgruppen (70) gebildet, die einem zugeordneten Lichtintensitätsbereich entsprechen. Der örtliche Verlauf der Gruppen (70) wird dahingehend analysiert, ob er zu Abschattungen einer Photovoltaikanlage (PV1) führen kann.

Gemäß einer zweiten Ausführungsform wird eine Linie (111) aus dem Bereich der PV-Anlage zur Sonne (105) hin gebildet und ständig nachgeführt. Um die Linie (111) herum wird ein Bereich (113) festgelegt, innerhalb dessen sich eine Referenzlinie (117) befindet. Es wird der Durchzug von Wolken (121) über die Referenzlinie (117) analysiert.

Das Ergebnis der Analyse dient dazu, die elektrische Leistung der PV-Anlage durch Zuschalten eines Ersatzenergielieferanten auf einen Mindestwert aufzustocken oder durch Wegschalten von Verbrauchern so zu reduzieren, dass wichtige Verbraucher nicht unter einen Mindestwert an zugelieferter Energie fallen.

## Beschreibung

Die Erfindung betrifft ein Verfahren und eine Vorrichtung zur Prognose einer kommenden Abschattung einer an ein Versorgungsnetz angeschlossenen Photovoltaikanlage durch Wolkenbildung oder Wolkenbewegung.

Bei der Errichtung von Solarkraftwerken ist es in den Energie-Abnahmeverträgen mit dem zugehörigen Energieversorger zum Teil vorgesehen, eine vertraglich zugesicherte Mindestleistung innerhalb einer festgelegten Zeitspanne in das Versorgungsnetz einzuspeisen. So z.B. kann bei einem 2,4 Megawatt Solarkraftwerk gefordert werden, dass zwischen 11.00 Uhr und 17.00 Uhr eine Leistung von mindestens 60 Prozent, also ca. 1,5 Megawatt, einzuspeisen ist. Je nach Wetterlage ist die Mindestleistung nicht immer alleine von der Solaranlage erzeugbar. Dann müssen Ersatzkraftwerke auf Gleichstrombasis, wie z.B. eine Batterie oder eine Brennstoffzelle, hinzugeschaltet werden. Bei länger prognostizierter Energieminderung muss dann auf der Wechselstrom-Seite ein Zusatzkraftwerk in die Pflicht genommen werden. Dies geschieht entweder durch Zukauf der benötigten Energie bei einem anderen Energielieferanten oder durch Zuschalten eines Zusatzkraftwerkes auf der Wechselstromseite, z.B. in Form eines Dieselgenerators oder eines Gaskraftwerkes. Die in Frage kommenden Energielieferanten haben unterschiedliche Rüstzeiten, bis ihre Energie eingespeist werden kann. Dies reicht vom quasi unmittelbaren Entladen einer Batterie bis hin zu ca. 5 Minuten für das Anfahren eines Zusatzkraftwerks.

Die Entscheidung, welche Maßnahme voraussichtlich die zweckmäßigste ist, ist in hohem Maße von der zu erwartenden Sonneneinstrahlung auf die Fläche der Photovoltaikanlage abhängig. Generell ist es für Energieversorger von Interesse, über eine sich anbahnende Verminderung der zur Verfügung stehenden Energie informiert zu sein. Dem kann dann zum Beispiel auch durch frühzeitiges Abschalten von Verbrauchern vom Netz begegnet werden, deren weiterer Betrieb sodann zu einem späteren Zeitpunkt wieder aufgenommen werden kann.

Eine solche Vorgehensweise ist beispielsweise bei der Herstellung von Wasserstoff sinnvoll.

Entsprechend liegt der Erfindung die Aufgabe zugrunde, ein Verfahren und eine Vorrichtung anzugeben, um eine drohende Unterversorgung zu erkennen und ihre voraussichtliche Dauer und Schwere einzustufen, damit die Auswahl getroffen werden kann, welcher zusätzliche Energielieferant zur Einspeisung vorbereitet und bereitgestellt werden sollte, damit die gewünschte Mindestleistung zu jeder Zeit abrufbar ist, oder damit alternativ die Wegnahme von Verbrauchern vom Netz einzuleiten.

Diese Aufgabe wird erfindungsgemäß durch ein Verfahren gelöst, bei dem die Bildung und/oder die Bewegung von Wolken in einem vorgebbaren Bereich zwischen der PV-Anlage und einem von ihr aus einsehbaren Teil des Firmaments analysiert wird, und bei dem in Abhängigkeit des Analyseergebnisses eine Entscheidung getroffen wird, ob eine Maßnahme zur Aufrechterhaltung einer Mindesteinspeise-leistung in das Versorgungsnetz oder ob eine Maßnahme zur Abschaltung zumindest eines von Verbrauchers zu ergreifen ist.

Wie bereits erwähnt, kann die genannte Maßnahme insbesondere die Einspeisung von Zusatzenergie, zusätzlich zu der von der PV-Anlage erzeugten Energie mittels eines Zusatzenergielieferanten, in das Versorgungsnetz sein, oder sie kann das Trennen von weniger relevanten Verbrauchern mit entsprechend geringer Priorität vom Netz sein.

Eine erste Ausführungsform des Verfahrens sieht vor, dass der vorgebbare Bereich von einer Digitalkamera aufgenommen wird, dass in zeitlichen Abständen Bilder des Bereichs aufgenommen werden, die sich aus einer Vielzahl von Pixeln zusammensetzen, dass in den Bildern der errechnete Sonnenstand berücksichtigt ist, dass aufeinander folgende Bilder miteinander verglichen werden, und dass die Veränderung der Helligkeit der Pixelpunkte in Bezug auf den Sonnenstand und den Bezugspunkt analysiert wird.

Diese Vorgehensweise bietet den Vorteil, dass ein großer Teil des Firmaments beobachtet wird und Wolkenveränderungen und -bewegungen quasi bis zum Horizont verfolgt und analysiert werden können. Unter der Markierung des Sonnenstandes in den Bildern wird dabei nicht notwendigerweise eine sichtbare Markierung verstanden. Es soll zum Ausdruck gebracht werden, dass in den Bildern der Ort, an dem sich die Sonne im Firmament zum Zeitpunkt der Aufnahme befindet, informationstechnisch eingearbeitet ist. Dies kann zusammen mit der Aufnahme der Bilder geschehen oder auch hinterher im Zuge der weiteren Verarbeitung der Bildinformationen.

Es muss nicht jeder einzelne Pixelpunkt getrennt verarbeitet werden. Es ist ebenso möglich, je nach Auflösungsvermögen der Kamera mehrere benachbarte Pixel zusammenzufassen und als einen Pixelverbundpunkt, Pixelgroßpunkt oder Pixelsammelpunkt zu betrachten.

Unter dem Merkmal "dass die Veränderung der Helligkeit der Pixelpunkte in Bezug auf den Sonnenstand und den Bezugspunkt analysiert wird" ist zu verstehen, dass die Veränderung der Helligkeit jedes Pixels von Bild zu Bild erfasst wird, und dass analysiert wird, inwiefern die Veränderung angelegt ist, auf eine Wolkenverschattung des Bezugspunktes für die Sonnenstrahlung zu schließen.

Die zeitlichen Abstände können regelmäßig sein, wobei dann direkt aufeinanderfolgende Bilder miteinander verglichen werden. So z.B. kann alle 2 bis 5 Sekunden ein Bild generiert werden, welches mit dem vorhergehenden verglichen wird. Wenn sich, wie es z.B. bei sonnigem oder diesigem Wetter der Fall ist, über einen gewissen Zeitraum keine Änderungen eingestellt haben, kann dieser Zeitraum nach und nach vergrößert und nach Feststellung einer Änderung wieder verkleinert werden.

Um Muster in der Veränderung zu erkennen, ist es zweckmäßig, nicht nur direkt aufeinander folgende Bilder, sondern Gruppen von Bildern zu vergleichen. Wenn nur direkt aufeinander folgende Bilder verglichen werden, kommt eher eine instabile, lineare Interpolation zustande. Mit der Analyse von Bildfolgen können stabile lineare Trends erkannt werden, um diese in die Zukunft zu extrapolieren.

Um der Nachbildung einer Wolke möglichst nahe zu kommen, ist es zweckmäßig, dass eine Anzahl an zusammenhängenden Pixelpunkten, die die gleiche oder in einem vorgebbaren Abweichungsbereich liegende Lichtintensität aufweisen, zu einer Gruppe zusammengefasst werden, und dass die Wanderung dieser Gruppe über den Bildbereich hin zu anderen Pixelpunkten verfolgt wird. So werden z.B. dunkle Bildpunkte, deren Strahlenintensität lediglich 10 % bis 15 % der für den errechneten Sonnenstand maximalen Intensität aufweist, zu einer Gruppe zusammengefasst. Bei der nächsten Aufnahme werden einige Pixel aus dieser Gruppe herausfallen, weil sie heller geworden sind und dann einer anderen Gruppe zuzuordnen sind. Andere, zuvor hellere Pixel werden entsprechend dunkler werden und in die betroffene Gruppe aufgenommen werden. Es findet also von Bild zu Bild eine Veränderung der vorliegenden Lichtintensitätsverteilung im betrachteten Bereich statt.

Es ist zweckmäßig, dass mehrere Gruppen mit jeweils gleicher oder auch unterschiedlicher Lichtintensität gebildet werden, und dass jeder Gruppe ein Bewegungsvektor zugeordnet wird, dessen Länge der mittleren Intensität oder Geschwindigkeit aller beteiligten Pixel der jeweiligen Gruppe entspricht und dessen Richtung der mittleren Verschiebungsrichtung der Lichtintensitäten im Bild entspricht. Der Kehrwert sagt dabei nichts anderes aus, als dass eine niedrige Intensität oder Helligkeit, die auf eine Wolke schließen lässt, und entsprechend bedeutsam für eine Abschattung sein kann, einen entsprechend längeren Vektor bildet.

Aus den beiden Parametern i) räumliche Ausdehnung der Gruppe und ii) Wanderungsrichtung der Gruppe können Rückschlüsse darauf gezogen werden, ob und wie die Gruppe eine Linie zwischen dem Bezugspunkt und der Sonnenmarkierung durchquert. Es können noch weitere Parameter, wie zum Beispiel die Rotation, das Wachstum, der Schwund oder die Veränderung der Intensität berücksichtigt werden

Diese zuvor betrachtete erste Ausführungsform hat den Vorteil, dass sie Wolkenbewegungen unabhängig von ihrer Höhe und der dort herrschenden Windrichtung berücksichtigt. Es wird also erfasst, wenn in ein und demselben Bereich eines Bildes unterschiedlich gerichtete Wolkenbewegungen stattfinden, wie z.B. eine kleine schwarze Wolke, die niedrig fliegt und sich vor eine hellere, höher gelegene Wolke schiebt. Es können damit alle Wolkenbewegungen, die die Tendenz zeigen, sich dem Bezugspunkt unter Abschattung der Sonnestrahlung zu nähern, herausgefiltert und näher betrachtet werden. Ebenso können Wolken, die sich zwar dem Bezugspunkt nähern, nicht aber dessen Linie zur Sonne schneiden, weggefiltert werden.

Die zweite Ausführungsform geht von der Überlegung aus, dass man bei Kenntnis der Windrichtung von dem Bezugspunkt aus gesehen quasi neben die Sonne sehen kann, um zu erkennen, was an Wolkenbewegung in Richtung Bezugspunkt unterwegs ist und später zu einer Abschattung führen wird. Ausgehend von diesem Ansatz sieht eine Alternative zur vorhergehenden Ausführung vor, dass eine Linie ausgehend von der PV-Anlage oder ihrer unmittelbaren Umgebung hin zum aktuellen Sonnenstand ermittelt wird, dass der vorgebbare Bereich um diese Linie herum gebildet wird, und dass der Durchzug der Wolken durch diesen Bereich ermittelt wird. Auf diese Weise wandert der Bereich quasi mit dem Sonnenstand mit, und es wird immer das Gebiet zwischen der PV-Anlage und der Sonne beobachtet. Um Wolkenbewegung zu analysieren, ist in den Bereich eine horizontale Referenzlinie gelegt, und es wird der Durchzug oder das Überschreiten der Wolken in Bezug auf diese Referenzlinie ausgewertet. Eine zweite, parallel zur ersten Referenzlinie befindliche Referenzlinie ermöglicht die Feststellung der Geschwindigkeit des Wolkenzuges.

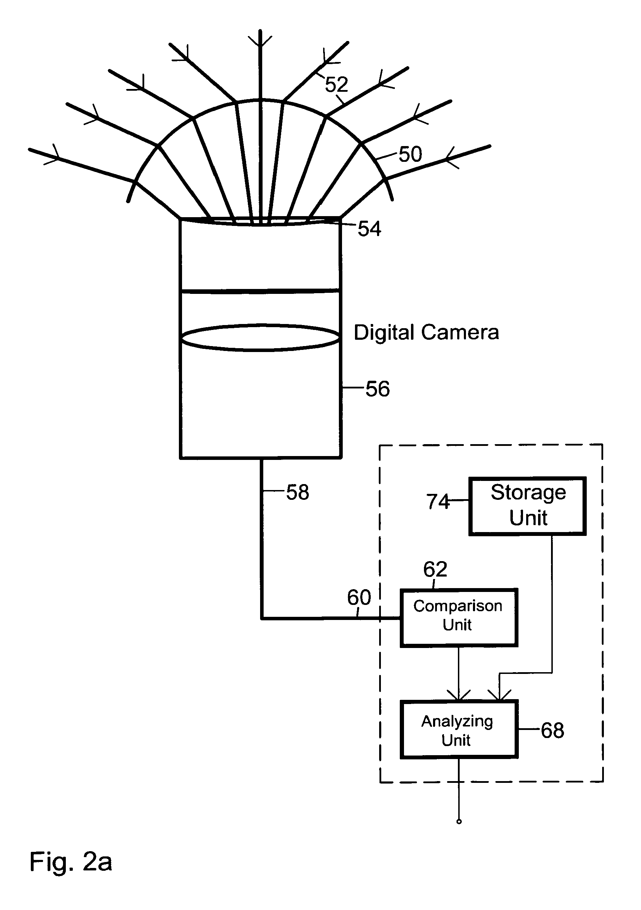

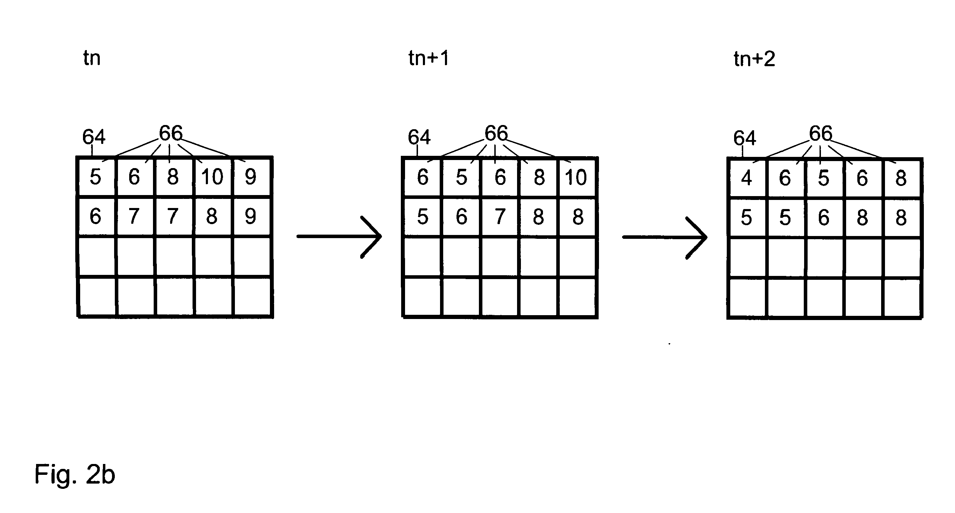

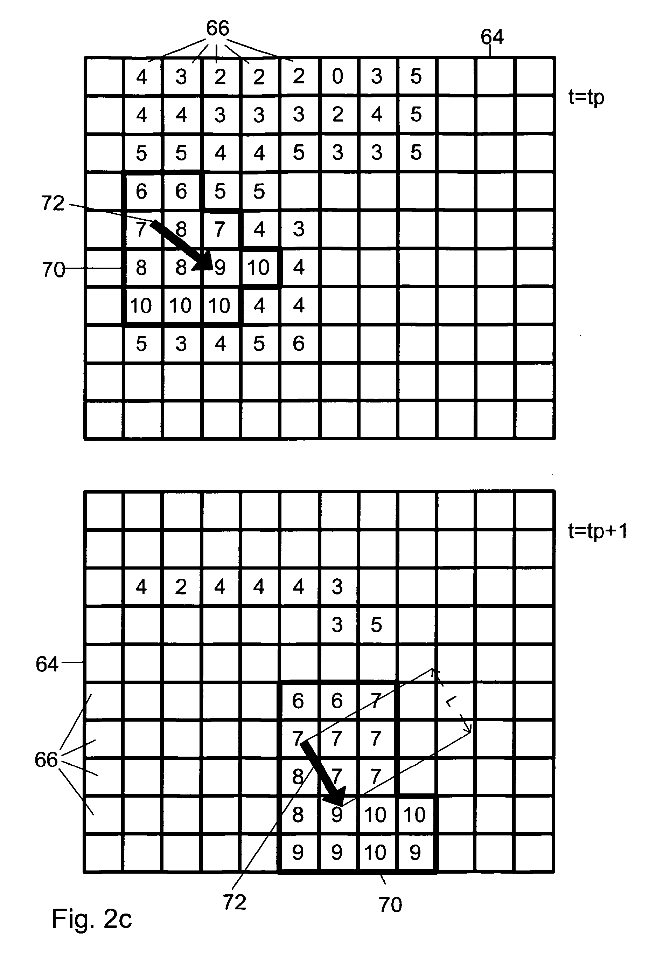

Da es uninteressant ist, wie sich die Wolkenbewegung oder -bildung nach Durchzug über der PV-Anlage weiterentwickelt, sollte der Bereichsrand in Bezug zu der Linie so gelegt werden, dass er in die herrschende Windrichtung gesehen dicht an der Linie liegt und in Gegenwindrichtung gesehen weit entfernt von der Linie liegt. Der Bereich ist dann vorteilhafterweise rechteckig oder elliptisch, und die Linie liegt dann an der schmalen Kante des Rechtecks bzw. in der Nähe des Brennpunkt der Ellipse, der in Windrichtung liegt. Dieses wird später anhand der Figur 2 nochmals verdeutlicht.

Die Größe des Bereichs ändert sich permanent mit dem Sonnenstand, also dem Winkel zwischen der Linie und der Bodenfläche, auf der die Photovoltaikmodule montiert sind. Wenn die Sonne senkrecht über der Photovoltaikanlage steht, sollte der Bereich eine Ausdehnung von ca. 5 bis 100 Quadratkilometern haben, je nachdem, wie hoch die Wolkendecke liegt. Bei niedrig vorbeiziehenden Wolken ist ein größerer Bereich zu empfehlen als bei hoch liegender Wolkenbewegung.

Wie es oben ausgeführt ist, kann eine aus dem Analyseergebnis zu treffende Maßnahme die Einspeisung von Zusatzenergie, zusätzlich zu der von der Photovoltaikanlage erzeugten Energie mittels eines Zusatzenergielieferanten, in das Versorgungsnetz sein. Insbesondere bei Einsatz von elektro-mechanischen DC-AC Wandlern unter Verwendung eines Gleichstrommotors in Kombination mit einem Synchronmotor (wobei der Gleichstrommotor von der Photovoltaikanlage gespeist wird) kommt auch eine Batterie als Zusatzenergielieferant in Frage. Bei Abfall der Solaranlage unter die Mindestleistung wird also vom Zusatzenergielieferanten her der Fehlbetrag eingespeist.

Da eine Batterie nur über einen beschränkten Zeitraum von einigen Minuten den Fehlbetrag an Energie ausgleichen kann, ist es sinnvoll, ein Ersatzkraftwerk zur Einspeisung ins Netz vorzubereiten, sobald sich abzeichnet, dass die bei der Photovoltaikanlage vorliegende Unterschreitung der Mindestleistung nicht nur vorübergehender Natur ist, wie z.B. eine einzelne vorbeiziehende Wolke. Insofern sollte das Zuschalten der Batterie mit dem Anfahren eines Ersatzkraftwerks oder dem Zuschalten eines bereits laufenden Ersatzkraftwerks verbunden werden. Das Ersatzkraftwerk ist zur Lieferung von Gleichstrom geeignet und kann dabei ein herkömmlicher Dieselgenerator mit Gleichrichter sein, der in ca. 1 Minute die ergänzende Leistung zur Verfügung stellen kann, oder aber eine Brennstoffzelle. Die Zeitspanne, die zwischen der Anforderung durch die Steuer- und Regeleinheit bis zum eigentlichen Zuschalten auf den Gleichstrommotor vergeht, liegt also vorteilhafterweise zwischen 1 und 5 Minuten, insbesondere zwischen 2 und 4 Minuten.

Ein Kriterium, das zu dem Anfordern der zusätzlichen Kraftwerksleistung führt, kann zum Beispiel sein, dass die von den Photovoltaik-Modulen erzeugte elektrische Leistung über eine vorgebbare Zeitspanne hinweg einen Mindestwert unterschreitet. Ein anderes Kriterium kann sein, dass das Produkt aus der von den Photovoltaik-Modulen erzeugten elektrischen Leistung einerseits und einer Zeitspanne andererseits (also das Integral über die Leistung) einen vorwählbaren Mindestwert unterschreitet. Es sind weitere Kriterien vorstellbar, die die Natur des beobachteten Leistungsabfalls der Photovoltaikanlage berücksichtigen, wie z.B. harte Schatten, Lichtwechsel, Schäfchenwolken, Hochnebel, etc.

Hier greift vorliegende Erfindung ein, indem eben diese Wetterparameter nicht aktuell durch die von der Photovoltaikanlage erzeugte Energie ausgewertet werden, um im Nachhinein eine Entscheidung zu treffen, sondern um die Abschattungsparameter im Vorfeld des Wettergeschehens zu prognostizieren, damit die Entscheidung über die zweckmäßigste Art des Zusatzenergielieferanten (oder des Verbraucherabschaltens) getroffen werden kann, bevor die Abschattungssituation tatsächlich eingetroffen ist.

Bezüglich der Vorrichtung zur Durchführung des Verfahrens nach einem der Ansprüche 3 bis 7 zeichnet sich die Erfindung a) durch eine Fischaugenoptik, die den einsehbaren Teil des Firmaments zumindest teilweise auf die Optik einer Digitalkamera zur Bildung des vorgebbaren Bereichs abbildet, b) durch ein Speicherbauteil, in welches in zeitlichen Abständen aufgenommene Bilder des Bereichs abgelegt sind, c) durch einen Speicher, in den die Koordinaten des Sonnenverlaufs eingeschrieben sind, und d) durch eine Recheneinheit aus, der der zu einem Zeitpunkt vorliegende Sonnenstand zusammen mit mindestens zwei abgespeicherten Bildern zugeführt sind, und die die mindestens zwei Bilder miteinander vergleicht und die Veränderung der Helligkeit der Pixelpunkte der Bilder in Bezug auf den Sonnenstand analysiert.

Eine Fischaugenoptik ist per se bekannt. Sie ermöglicht die komplette Abbildung des einsehbaren Firmaments auf eine Kamera. Durch diesen großen Beobachtungsraum kann die Fischaugenoptik dezentral zu einer einzelnen Photovoltaikanlage angeordnet sein. Sie kann zum Beispiel mittig von drei Solarfeldern (PV-Anlagen) liegen und dann entsprechend drei Bezugspunkte, jeden für eine PV-Anlage, für die Berechnung berücksichtigen. Es sind frühe erste Prognosen möglich, da de facto bis zum Horizont geschaut werden kann. Ein sich zusammenziehendes Gewitter ist z.B. sehr früh zu erfassen. Außerdem ist diese Ausführung nicht abhängig von der Windrichtung, da der gesamte Raum über den PV-Anlagen beobachtet werden kann.

Die Vorrichtung zur Durchführung des Verfahrens nach einem der Ansprüche 8 bis 12 ist gekennzeichnet durch einen Lichtdetektor, der eine Vielzahl von matrixartig angeordneten Photozellen aufweist, und durch ein Analysegerät, das das auf die Photozellen einfallende Licht auf seine Verteilung auf der Matrix und auf seine Intensität hin analysiert.

Oberhalb des Lichtdetektors ist eine Linse angeordnet, die den Bereich auf die Oberfläche des Lichtdetektors abbildet. Es ist vorteilhafterweise eine Steuervorrichtung vorgesehen, die die Linse so nachführt, dass ihre optischen Zentralachse in Richtung Sonne weist. Dabei sollte der Lichtdetektor aus einer Vielzahl von Photozellen, z.B. zwischen 50 und 500, bestehen, die matrixartig angeordnet sind. Bei der Wahl eines elliptischen Bereichs sollte die Linse dann ebenfalls elliptisch sein. Ein Analysegerät wertet das auf die Matrix einfallende Licht entsprechend seiner Verteilung auf die Vielzahl der Photozellen und seine Intensität bezüglich der einzelnen oder zu Gruppen zusammengefassten Photozellen aus. Die zuvor angesprochene horizontale Referenzlinie wird durch eine Anzahl von Photozellen gebildet, die auf einer Geraden liegen und die vorzugsweise am Rand der Matrix verläuft. Die Lage des Randes ist von der Windrichtung abhängig. Die Gerade verläuft entlang des Randes der Matrix, der in Windrichtung liegt. Zu diesem Zweck ist die Vorrichtung drehbar ausgelegt, um sie entsprechend der Windrichtung so auszurichten, dass der Wolkenzug auf der Matrix nachgebildet wird, bevor er die Photovoltaikanlage erreicht.

Auf das Analysegerät soll in dieser Anmeldung nicht weiter eingegangen werden. Solche Geräte sind per se bekannt, zum Beispiel auf dem Branderkennungsgebiet. Dort wird zum Beispiel der Horizont oberhalb eines Waldstücks dahingehend beobachtet, ob sich weiße oder dunkle Brandwolken ausbreiten.

Weitere Vorteile und Ausgestaltungen der Erfindung ergeben sich aus der Beschreibung von Ausführungsbeispielen anhand der Figuren. Es zeigen:
- Fig.1: ein Prinzipschaltbild eines elektromechanischen Konverters mit zwei Gleichstrommotoren, einem Drehstromgenerator, einer Batterie, einem Ersatzkraftwerk und einem Zusatzkraftwerk, gemäß der älteren, nicht veröffentlichten Patentanmeldung Ad 21/09 EU, US = BECK-9 = US 12/763,634);
- Fig.2: ein Prinzipbild einer Vorrichtung zur Durchführung des erfindungsgemäßen Verfahrens;
- Fig.3: ein Analyseergebnis, erzielt nach einer ersten Ausführungsform der Erfindung;
- Fig.4: eine Schemadarstellung zur Funktionsweise des Verfahrens bei zwei unterschiedlichen Sonnenständen und Windrichtungen nach einer zweiten Ausführungsform;
- Fig.5: eine Prinzipbild der Vorrichtung zur Durchführung des Verfahrens; und
- Fig.6: eine Photozellenmatrix mit Verteilung von auftreffendem Licht bei einer Wolke.

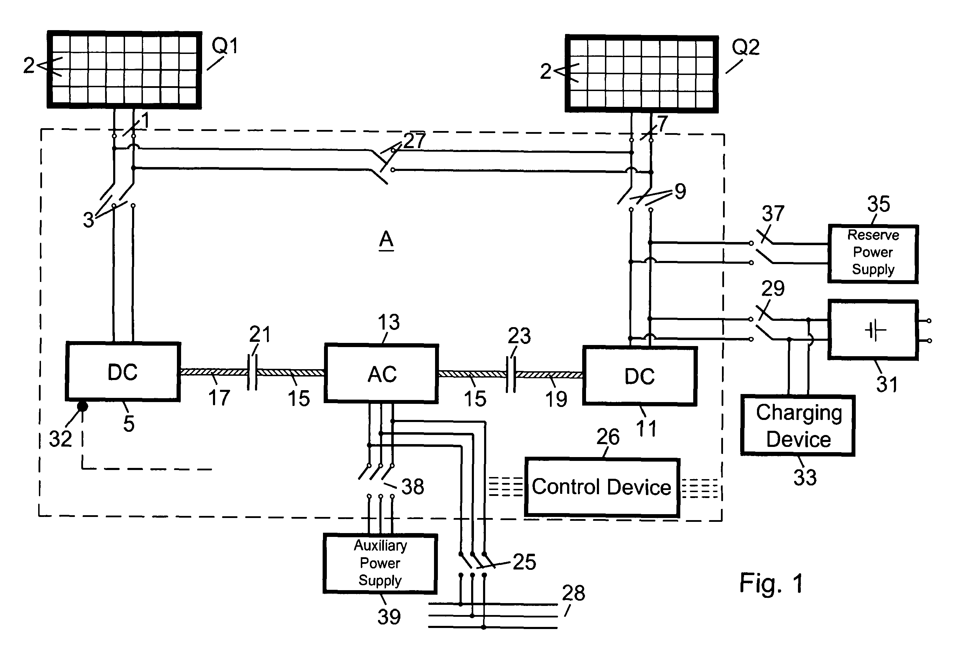

In der Figur 1 ist in einer Photovoltaik-Anlage A mit Q1 eine erste Menge an Photovoltaikmodulen (in Figur 1 nicht im einzelnen gezeigt) als erste Energiequelle bezeichnet, die ein erstes Ausgangsklemmenpaar 1 aufweist, an denen eine Gleichspannung und ein Gleichstrom abgreifbar sind. Über einen ersten Schalter 3 ist das Ausgangsklemmenpaar 1 mit einem ersten fremderregten Gleichstrommotor 5 verbindbar, um diesen anzutreiben.

Analog hierzu befindet sich auf der rechten Figurenseite eine zweite Menge Q2 an Photovoltaikmodulen als zweite Energiequelle, die ein zweites Ausgangsklemmenpaar 7 aufweist, an denen eine Gleichspannung und ein Gleichstrom abgreifbar sind. Über einen zweiten Schalter 9 kann das Ausgangsklemmenpaar 7 mit einem zweiten fremderregten Gleichstrommotor 11 verbunden werden, um diesen anzutreiben.

Zwischen den beiden Gleichstrommotoren 5, 11 ist ein Drehstromgenerator 13 angeordnet, dessen Welle 15 mit den beiden Motorachsen 17, 19 der Gleichstrommotoren 5 bzw. 11 fluchtet. Die Generatorwelle 15 ist links und rechts vom Drehstromgenerator 13 herausgeführt und am jeweils freien Ende mit einer Kupplung 21 bzw. 23 versehen. Mittels der Kupplungen 21, 23 sind die Achsen 17, 19 der Gleichstrommotoren 5, 11 getrennt mit dem Drehstromgenerator 13 verbindbar. Es kann alternativ auch eine starre Verbindung ohne Kupplungen 21, 23 vorgesehen sein. Der Drehstromgenerator 13 weist ein elektrisches Anschlusselement 25 mit einem Schalter auf, um ihn zwecks Weitergabe seiner Wechselspannung an ein Stromversorgungsnetz (in Figur 1 außerhalb von A gezeigt) anzuschließen.

Es ist eine Steuer- und Regeleinheit 26 vorgesehen, die die Schalter 3 und 9 steuert. Sie kann auch die Kupplungen 21, 23 trennen oder zusammenfügen. Die Steuer- und Regeleinheit 26 ist mit einem Signalgenerator ausgerüstet, der die Betätigung eines Brückenschalters 27 steuert, mit dem die Ausgangsklemmen 1 und 7 miteinander verbunden werden können. Beim Anfahrbetrieb des ersten Gleichstrommotors 5 ist der Brückenschalter 27 geschlossen, und die Leistung der zweiten Energiequelle Q2 steht neben der Leistung der ersten Energiequelle Q1 am Eingang des ersten Gleichstrommotors 5 zur Verfügung. Erreicht die Leistung des ersten Gleichstrommotors 5 einen vorgegebenen Wert, insbesondere z. B. seine Nennleistung, wird der Brückenschalter 27 geöffnet. Die von der Energiequelle Q2 erzeugte elektrische Energie wird dann zum Anfahren und weiteren Betrieb des zweiten Gleichstrommotors 11 verwendet. Ist die Drehzahl von dessen Achse 19 an die der Welle 15 angepasst, wird von der Steuer- und Regeleinheit 26 ein Signal zur Einleitung des Einkupplungsvorgangs der Kupplung 23 gegeben. Nach erfolgter Ankopplung bilden die Achsen 17, 19 zusammen mit der Welle 15 einen gemeinsamen Drehverbund.

An dem zweiten Gleichstrommotor 11 ist über einen Batterieschalter 29 eine Batterie 31 zuschaltbar. Die Batterie 31 wiederum ist, gegebenenfalls über einen weiteren, nicht gezeigten Schalter, mit einem Ladegerät 33 verbunden, insbesondere einem Gleichrichter-Ladegerät, das z. B. aus dem Stromversorgungsnetz 28 gespeist wird.

Für den Fall, dass an dem Anschlusselement 25 keine festgelegte Mindestleistung in das Stromversorgungsnetz 28 eingespeist werden kann, ist die Steuer- und Regeleinheit 26 dazu ausgebildet, zunächst den Schalter 9 zu öffnen, über eine Änderung der Erregung des zweiten Gleichstrommotors 11 dessen Motorspannung auf die Batterieleerlaufspannung zu regeln und anschließend den Batterieschalter 29 zu schließen, um zusätzlich zu der Solarenergie weitere Energie in die Anlage A einzuspeisen. Der Einspeisevorgang wird dadurch erreicht, dass nach dem Schließen des Batterieschalters 29 die Motorspannung am zweiten Gleichstrommotor 11 verringert wird, was einen Leistungsfluss von der Batterie 31 in den zweiten Gleichstrommotor 11 hinein bewirkt.

Vorzugsweise ist sowohl der erste Gleichstrommotor 5, als auch der zweite Gleichstrommotor 11 an die Batterie 31 anschließbar. Dabei spielt es keine Rolle, ob ein Umschalter vorgesehen ist oder ob die Batterie 31 in zwei getrennte Batterien, z. B. 31 a, 31 b, aufgeteilt ist, von denen eine dem ersten Gleichstrommotor 5 zugeordnet ist und die andere dem zweiten Gleichstrommotor 11. Diese Maßnahme ist im Zusammenhang mit der folgenden Betrachtung zur Erwärmung der Gleichstrommaschinen 5, 11 von Bedeutung.

Zur Schonung der Gleichstrommaschinen 5, 11 ist zweckmäßigerweise eine Einrichtung zur Temperaturüberwachung vorgesehen. Dabei ist vorgesehen, dass die Steuer- und Regeleinheit 26 von einem Sensor 32 mit dem Messwert der Temperatur des ersten Gleichstrommotors 5 versorgt wird. Angenommen, der erste Motor 5 läuft an und der zweite Motor 11 läuft an der Batterie 31. Am ersten Motor 5 besteht die Gefahr der Überhitzung. Nun erfolgt eine Sicherheitsmaßnahme dadurch, dass bei Überschreiten einer vorgegebenen Grenztemperatur ein Wechsel erfolgt derart, dass die Einspeisung von der Batterie 31 an den bisher von der Photovoltaikanlage Q1 und Q2 versorgten ersten Gleichstrommotor 5 auf den anderen Gleichstrommotor 11 übergeht, und dass der andere, bisher lediglich von der Batterie 31 angetriebene zweite Gleichstrommotor 11 nun von der Photovoltaikanlage Q1+Q2 angetrieben wird. Die Verhältnisse werden also vertauscht.

Besonders vorteilhaft ist es, wenn beide Gleichstrommotoren 5, 11 mit einer Einrichtung zur Temperaturüberwachung versehen sind, da sowohl der Gleichstrommotor, der mit der gesamten Last der Photovoltaikanlage beaufschlagt wird, überhitzen kann, als auch der andere Gleichstrommotor, der mit dem hohen Batteriestrom bei niedriger Spannung gespeist wird. Hier sollte die Steuer- und Regeleinheit 26 einen Ausgleich schaffen, indem eventuell mehrmals zwischen den Energiequellen, nämlich Solarenergie einerseits und Batterie 31 (Ersatzquelle) andererseits, gewechselt wird.

Die Gleichstrommotoren 5, 11 können trotz ihrer Belastung mit nur einem Teil der Gesamtnennleistung doch einzeln überlastet werden. Dieser Fall liegt vor, wenn die Mindestleistung von z.B. 70 % der Nennleistung (erste und zweie Energiequelle Q1, Q2 zusammengenommen) nicht erreicht wird, wenn die PV-Anlage (Q1 und Q2 zusammen) aber immerhin doch 60% ihrer Nennleistung erbringt. Dann erfolgt die Umleitung der von der zweiten Energiequelle Q2 gelieferten Energie mittels Schließens des Brückenschalters 27 auf die erste Gleichstrommaschine 5, die dann mit 60% der Gesamtenergie belastet wird. Dies bedeutet, bezogen auf die halbe Gesamtleistung, die auf diesen Gleichstrommotor 5 entfällt, eine Überlast um 20 %.

Dies wird an einem Zahlenbeispiel deutlich: Es liegt eine Solaranlage mit einer Gesamtleistung von 2,4 Megawatt vor, die in gleich große Anlagenteile geteilt ist, so dass die Leistung von Q1 gleich der von Q2 also jeweils gleich 1,2 Megawatt beträgt. Die aktuelle Sonneneinstrahlung liefert eine Leistung von 1,4 Megawatt, zur Einhaltung des Liefervertrages mit dem Energieversorger sind aber 70% der Nennleistung, entsprechend 1,68 Megawatt, zu liefern. Nach dem Öffnen des Schalters 9 und Schließen des Brückenschalters 27 liegen an dem ersten Gleichstrommotor 5 also 1,68 Megawatt an, das bedeutet 0,24 Megawatt (= 20% der Nennleistung) mehr als für den Dauerbetrieb des ersten Gleichstrommotors 5 ausgelegt ist. Der zweite Gleichstrommotor 11 wird aus der Batterie mit den fehlenden 0,24 Megawatt versorgt, was bei einer Batteriespannung von 100 Volt einem Strom von 2400 Ampere entspricht.

Es ist also sinnvoll, beide Gleichstrommotoren 5, 11 mit einer Einrichtung zur Temperaturüberwachung zu versehen, die die Überhitzung vermeiden hilft. Wenn die reduzierte Leistung der Photovoltaikanlage (Q1 + Q2) über einen längeren Zeitraum von mehreren Minuten dauern könnte, sollte zur Sicherstellung der Lieferung einer Mindestmenge an Energie in das Stromnetz 28 auf die in der Figur 1 gezeigte Ausführungsform zurückgegriffen werden.

In der Figur 1 ist ferner ein DC-Ersatzkraftwerk 35, welches mittels eines Zusatzschalters 37 an den zweiten Gleichstrommotor 11 anschließbar ist, gezeigt. Die Batterie 31 kann nur zu einer kurzzeitigen Überbrückung eines Engpasses dienen, um die zugesagte Leistung der PV-Anlage A zu erbringen. Bei einer andauernden Minderleistung ist es vorgesehen, das Ersatzkraftwerk 35 anstelle der Batterie 31 an den zweiten Gleichstrommotor 11 anzuschließen. Je nach gewähltem Ersatzkraftwerk 35 sind unterschiedliche Anfahrzeiten erforderlich, um das Ersatzkraftwerk 35 zuschaltfertig zu machen. So beträgt die Vorbereitungszeit bis zum Zuschaltzustand bei einem Dieselgenerator mit Gleichrichter ca. 1 Minute, wohingegen sie bei einer Brennstoffzelle bis zu mehreren Minuten dauern kann. Entsprechend ist die Steuer- und Regeleinheit 26 so auszulegen, dass das Ersatzkraftwerk 35 frühzeitig angefahren wird, bevor die Gefahr droht, dass die Batterie 31 nicht mehr bis zum Zuschaltzeitpunkt durchhält.

Ein Kriterium für die Initiierung des Zuschaltvorgangs kann sein, dass die von den Photovoltaik-Modulen erzeugte elektrische Leistung über eine vorgebbare Zeitspanne hinweg einen Mindestwert unterschreitet. Das heißt z.B. dass der Zuschaltvorgang eingeleitet wird, wenn innerhalb eines Zeitraums von 1 Minute die Photovoltaikanlage Q1, Q2 unterhalb der Mindestleistung blieb und die Batterie 31 während dieser einen Minute zugeschaltet werden musste. Ein anderes Kriterium sieht vor, dass der Zuschaltvorgang dann erfolgt, wenn das Produkt aus von den Photovoltaik-Modulen erzeugter elektrischer Leistung und einer Zeitspanne eine vorwählbaren Mindestwert unterschreitet. Das heißt z.B., dass das Ersatzkraftwerk 35 zugeschaltet wird, wenn über einen Zeitraum von 6 Minuten hinweg eine elektrische Leistung von 20 % der Batteriekapazität aufgebraucht wurde, weil sie zur Aufstockung der Minderleistung zwecks Deckung der garantierten Leistungsabgabe herangezogen wurde.

Im Grunde genommen ist es unerheblich, ob die Kriterien so ausgelegt sind, dass das Ersatzkraftwerk vorbereitet wird, oder dass der Zuschaltzeitpunkt als Basis für die Berechnung dient. Im zweiten Fall muss dann die erforderliche Rüstzeit des Ersatzkraftwerks mit in die Berechnung einfließen.

Das Ersatzkraftwerk 35 dient zum einen dazu, die Batterie 31 zügig aufzuladen, und zum anderen zur Bereitstellung der Mindestleistung für eine relativ kurze Dauer von z.B. 5 bis 20 Minuten.

Sollte es absehbar sein, dass die Zusatzleistung von der Batterie 31 und dem Ersatzkraftwerk 35 über einen längeren Zeitraum von z.B. 20 Minuten bis zu mehreren Stunden erforderlich ist, wird mit einem Schalter 38 ein Zusatzkraftwerk 39 auf der AC-Seite hinzugeschaltet. Dieses Zusatzkraftwerk 39 kann räumlich getrennt an einer anderen Stelle im Versorgungsnetz 28 angeordnet sein. So kann es sich um ein Gaskraftwerk handeln, welches nach einer Rüstzeit von ca. 4 Minuten zur Einspeisung zur Verfügung steht. Das Anlaufenlassen und/oder das Zuschalten des Zusatzkraftwerks wird dann ebenfalls von der Steuer- und Regeleinheit 26 vorgenommen.

In der Figur 2a ist eine Fischaugenoptik 50 gezeigt, die die aus allen Richtungen einfallende Sonnenstrahlung 52 auf die Optik 54 einer Digitalkamera 56 bündelt. Diese Vorrichtungen sind an sich aus dem Stand der Technik bekannt. Die Kamera 56 weist einen elektrischen Ausgang 58 auf, der an den Eingang 60 einer Vergleichseinheit 62 gelegt ist. In der Vergleichseinheit 62 werden insbesondere aufeinander folgende Bilder der Kamera 56 miteinander verglichen, was zum Beispiel durch eine pixelweise Auswertung der einfallenden Lichtintensität erfolgen kann, wie es anhand der Figur 2b symbolhaft dargestellt ist. Der zeitliche Abstand der einzelnen auf einander folgenden Bilder kann jeweils bevorzugt gleich groß sein.

In der Figur 2b ist ein kleiner Ausschnitt 64 der Pixelmenge von drei Digitalbildern dargestellt, die aufeinanderfolgend zu den Zeitpunkten tₙ, tₙ₊₁ und tₙ₊₂ jeweils als Matrix erstellt wurden. An der linken Matrix sind beim Zeitpunkt tₙ in der obersten Reihe fünf nebeneinander liegende Pixel 66 eingezeichnet, die mit ihren zu dem Zeitpunkt tₙ vorliegenden Lichtintensitätswerten 5-6-8-10-9 behaftet sind. Die darunter liegende Reihe hat die Helligkeitswerte 6-7-7-8-9. Ein vergleichsweise großer Wert entspricht dabei einer vergleichsweise großen Intensität.

Bei der folgenden Aufnahme zum Zeitpunkt tₙ₊₁ hat sich die Bewölkung etwas verschoben und dazu geführt, dass der neu in den betrachteten Ausschnitt 64 der Matrix eingeführte Wert des ganz links gezeigten Pixels 6 beträgt und sich die anderen Pixel 66 der obersten Reihe ohne Veränderung ihrer Helligkeitswerte nach rechts verschoben haben. Bei dem zum Zeitpunkt tₙ₊₂ gezeigten Ausschnitt 64 der Pixelmenge fand in der obersten Reihe eine weitere Verschiebung statt, indem der linke Pixel 66 jetzt den Wert 4 angenommen hat und alle anderen unverändert nach rechts weitergeschoben wurden.

Anders verhält es sich in der unteren mit Intensitätswerten versehenen Reihe an Pixelpunkten 66. Dort hat sich zum Zeitpunkt tₙ₊₁ der zuvor mit 7 bewertete mittlere Pixelpunkt etwas aufgehellt und den Wert 8 (4. Pixelpunkt von links) angenommen. Ebenso ist es dem bei tₙ₊₁ mittleren Pixel des Werts 7 ein Bild später bei tₙ₊₂ ergangen. Er hat jetzt den Wert 8 erhalten Ebenso ist es dem bei t(n+1) mittleren Pixelpunkt des Werts 7 ein Bild später bei t(n+2) ergangen. Er hat jetzt den Wert 8 erhalten. Je nach verwendeter Kamera 56 wird dieser Vergleich für Tausende von Pixeln 66 durchgeführt.

Das Ausgangssignal der Vergleichseinheit 62 wird einer Rechen- oder Analyseeinheit 68 zugeführt, die die anhand der Figur 2a erläuterten Veränderungen der. Intensitätsverteilung auf der Matrix 64 auswertet. Die Auswertung umfasst dabei sowohl eine Änderung des Wertes der Pixel 66 als auch eine Analyse, wohin sich die hellen oder dunklen Bereiche verschoben haben. So zum Beispiel kann eine zusammenhängende Pixelgruppe von Helligkeitswerten zwischen 6 und 10 gebildet werden. Diese Pixelgruppe umfasst also je nach Bewölkung eine Vielzahl an Pixeln 66. Die Analyseeinheit 68 beobachtet dann die Verschiebung dieser Gruppe als Ganzes, wie es anhand der Figur 2c gezeigt ist. Im oberen Bild ist zu einem Zeitpunkt tp ein etwas größerer Matrixausschnitt 64 gezeigt, bei dem eine Gruppe 70 von zwölf zusammenhängenden Pixeln 66 vorliegt, die jeweils einen Intensitätswert zwischen 6 und 10 aufweisen. Ein Bild später zum Zeitpunkt tₚ₊₁ hat sich die Gruppe 70 etwas nach rechts unten verschoben; sie ist gleichzeitig größer geworden, indem sie jetzt siebzehn Pixel 66 umfasst, die in den vorgegebenen Helligkeitsbereich oder Abweichungsbereich zwischen 6 und 10 fallen. Jede Gruppe 70 kann mit einem Vektor oder Pfeil 72 versehen werden, der die Intensitätsverteilung innerhalb der Gruppe 70 charakterisiert. Die Länge L des Pfeils 72 ist ein Maß für die gemittelte Helligkeit der Gruppe 70. Durch den Vergleich der Pfeile 72 zu verschiedenen Zeitpunkten, z. B. zu tp und tₚ₊₁, lässt sich die Intensitätsverteilung zwischen den entsprechenden Bildern ermitteln. Diese Veränderung wird am deutlichsten dadurch dargestellt, indem jede Gruppe 70 mit einem Vektor 72 versehen wird. Auf diese Weise kann eine Vielzahl von Gruppen 70 (auch mit sich überschneidenden Mengen an Pixelpunkten) gebildet werden, die zum einen Teil dieselbe Intensitätsstärke wiedergeben und zum anderen Teil geringere oder höhere Intensitätsbereiche abdecken.

Auf die Figur 2a zurückkommend: dort ist weiterhin eine Speichereinheit 74 gezeigt, in welcher der Verlauf der Sonne aus Sicht der Fischaugenoptik 50 gespeichert ist. Wenn die Fischaugenoptik 50 am Ort der Photovoltaikanlage untergebracht ist, bildet sie gleichzeitig einen Bezugspunkt. Die Speicherung des Sonnenverlaufs kann z.B. über die Eingabe der Koordinaten geschehen, die den Sonnenstand zu einem vorgegebenen Zeitpunkt beschreiben. Es ist ausreichend, wenn für eine Zeitspanne von z.B. 10 Minuten jeweils die Koordinaten des zugehörigen Sonnenstandes abgespeichert sind, also sechs Koordinatenpaare pro Stunde Sonnenverlauf. Der Sonnenverlauf muss nicht in Tabellen abgelegt sein. Er kann auch anhand bekannter Formeln berechnet und zu jedem Bild gespeichert werden.

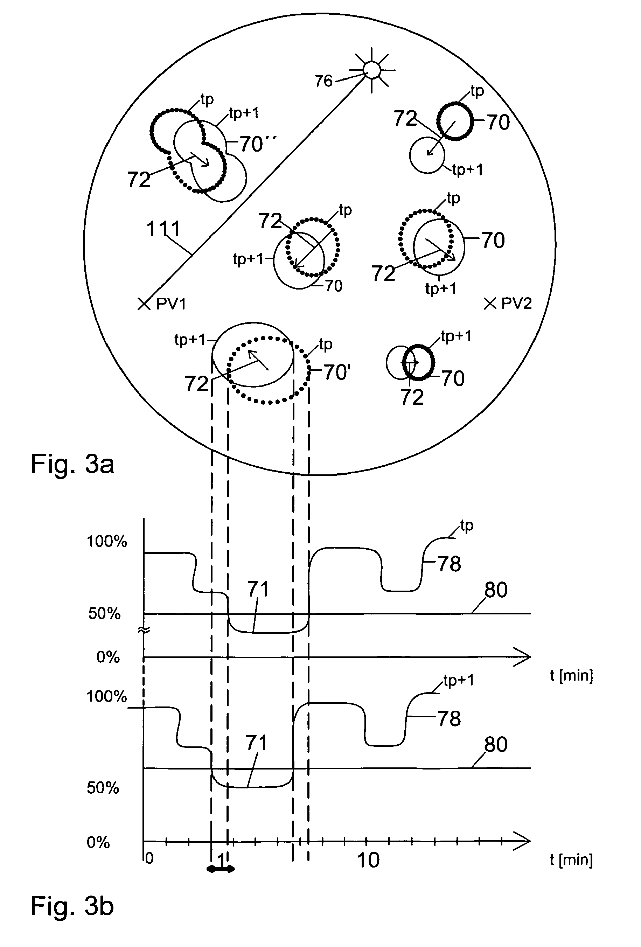

In der Analyseeinheit 68 werden die Eingangsdaten, d.h. die Kamerabilder oder -wie dargestellt in Fig. 2a - bereits deren Vergleich untereinander in der Vergleichseinheit 68, sowie die Sonnenstandskoordinaten so verarbeitet, dass sie in Bezug gesetzt werden zu dem oder den Bezugspunkt(en), also dem Ort, an dem die Photovoltaikanlage montiert ist. Ein typisches Ergebnis wird mit Hilfe der Figur 3a und 3b beschrieben.

In der oberen Figur 3a ist der gesamte einsehbare Bereich der Fischaugenoptik 50 als Kameraaufnahme abgebildet, so wie die Kameraaufnahme sich ergibt, wenn das gesamte einsehbare Firmament beobachtet werden soll. Es ist auch möglich, nur einen Teil des einsehbaren Firmaments zu beobachten. Der Einfachheit halber ist der Bereich als Kreis dargestellt, wobei die Standorte von zwei Photovoltaikanlagen PV1 und PV2 als unveränderliche Bezugspunkte eingezeichnet sind. Ebenso ist die sichtbar gemachte Position 76 der Sonne in das Kamerabild aufgenommen worden. Innerhalb des Kamerabildes befindet sich eine Vielzahl von Gruppen 70 mit ihren zugehörigen Vektoren 72. Auch dieses sich in der Figur 3a ergebende Bild ist wiederum nur die Momentaufnahme zu einem festgelegten Zeitpunkt t. Dieses Bild wird nach jedem aufgenommenen und analysierten Kamerabild neu erstellt.

Die untere Figur 3b zeigt für die erste Photovoltaikanlage PV1 einen beispielhaften Verlauf 78 der prognostizierten Intensität der auftreffenden Sonnenstrahlung über einen Zeitraum von einer Minute hinweg. Innerhalb dieses Zeitraums ist die Senke 71, die der Gruppe 70 unten links zugehört, nach links gewandert. In der Regel wird nicht nur eine einzige Gruppe 70 betrachtet. Es werden abweichend davon alle Vektoren 72 dahingehend ausgewertet, welche der Gruppen 70 sich dem Bezugspunkt PV1 nähern. Bei diesen wird festgestellt, wann sie ihn unter Berücksichtigung ihrer Wandergeschwindigkeit erreichen werden und wie lange sie über dem Bezugspunkt PV1 verweilen werden, bis sie an einen Ort weitergezogen sind, an dem keine Abschattung mehr droht. Im gezeigten Beispiel von Fig. 3a sind es die beiden Gruppen 70 und 70", von denen gemäß Vergleich von tp und tₚ₊₁ eine Gefahr ausgeht, dass sie sich zwischen den Sonnenstand 76 und den Bezugspunkt PV1 schieben. Entsprechend ist in der Figur 3b ein Intensitätsabfall in ca. 3 Minuten zu erwarten, der nach ca. 4 Minuten (entsprechend der Breite der Gruppe 70') vorbei ist. Die Intensität in der Senke 71 fällt unter einen Schwellwert 80, der bei 60% der für diesen Sonnenstand zu erwartenden maximalen Helligkeit liegt. Bei Abfall unter diesen Schwellwert 80 ist es angezeigt, den Energieversorger oder den Anlagenbetreiber zu informieren, dass eine nicht hinnehmbare Unterversorgung droht, so dass dieser daraufhin eine der eingangs genannten Maßnahmen ergreifen kann. Natürlich könnte diese Maßnahme auch sofort mit Hilfe der Steuer- und Regeleinheit getroffen werden.

Es ist selbstverständlich, dass die beschriebenen Komponenten, wie die Speichereinheit 74, die Vergleichseinheit 62, und die Analyseeinheit 68, nicht als getrennte Bauteile zu sehen sind, sondern eher die Funktion beschreiben, die bereitgestellt werden soll. Entsprechend sind diese Komponenten in einem einzigen elektronischen Bauteil realisierbar. Ebenso ist die zugeschriebene Funktion nicht selektiv zu betrachten. Das heißt, dass der Vergleich der Bilddaten und deren Analyse miteinander vermischt werden können, soweit es praktikabel ist.

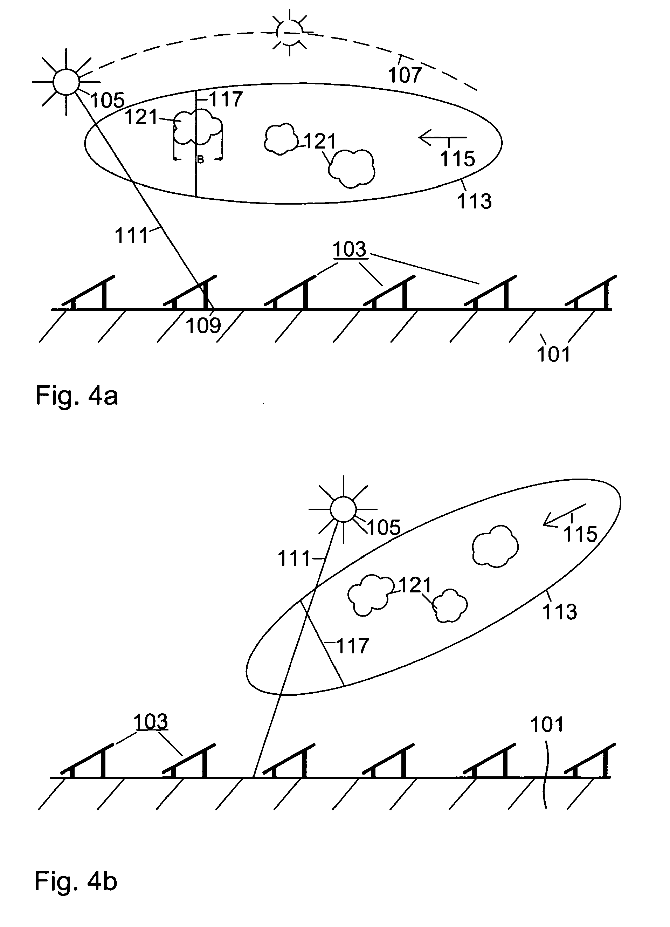

In den Figuren 4a und 4b ist schematisch dargestellt, wie auf einem Boden 101 eine Photovoltaikgroßanlage 103 von mehreren Megawatt Leistung in Nord-Süd Richtung ausgerichtet montiert ist. Über dem Boden 101 ist symbolisch die Sonne 105 gezeigt, die entlang dem Bogen 107 ihren Ost-West Verlauf nimmt.

Zwischen der Sonne 105 und einem Punkt 109 innerhalb oder in der näheren Umgebung der Photovoltaikanlage 103 befindet sich eine Linie 111. Sie ist eine ermittelte Linie 111, und sie ändert sich mit der Änderung des Sonnenstandes entlang des Bogens 107, vgl. Fig. 4b. Die Ermittlung der Linie 111 kann beispielsweise dadurch erfolgen, dass - ausgehend von dem Punkt 109 als Anfangspunkt - der hellste Punkt am Firmament als Endpunkt gewählt wird und die Linie 111 als Gerade durch diese beiden Punkte gebildet wird. In der Figur 4b ist die Linie 111 gegenüber Fig. 4a zu einem späteren Zeitpunkt des Tages eingezeichnet.

Um die Linie 111 herum ist ein Bereich 113 gebildet, der dasjenige Feld markiert, innerhalb dem die Wolkenbewegung stattfindet. Die Wolkenbewegung ist dabei durch einen Pfeil 115 symbolisiert, der die herrschende Windrichtung angibt. Der Bereich 113 ist dabei planparallel zur Bodenfläche 101 vorgegeben. Der Bereich 113 ist - der Übersichtlichkeit wegen - in Fig. 4a und 4b um 90° gekippt und jeweils als Ellipse dargestellt. Innerhalb des Bereichs 113 ist eine Referenzlinie 117 eingezeichnet, die im wesentlichen senkrecht zur Windrichtung 115 steht. An einer am Boden 109 befindlichen Auswerteeinrichtung (nicht gezeigt) wird das Passieren von Wolken 121 über die Referenzlinie 117 erfasst. Dabei wird ermittelt, wie lange sich die Wolke 121 durch die Referenzlinie 117 schiebt. Ebenso wird ermittelt, welche aktuelle oder mittlere Breite B die Wolke(n) 121 aufweisen. Aus diesen Daten wird errechnet, wie viel Zeit noch vergehen wird, bis die Wolke(n) 121 sich zwischen die PV-Anlage 103 und die Sonne 105 schiebt. Ebenso kann aus der Geschwindigkeit und Breite B der Wolke(n) 121 geschlossen werden, welches Ausmaß die Abschattung annimmt. Aus dem errechneten Ergebnis werden die Konsequenzen zur Bereitstellung von Zusatzenergie gezogen, die aufgrund der zu erwartenden Abschattung erforderlich sind, um die Mindestleistung der von der Photovoltaikanlage 103 in das Netz 28 eingespeisten Energie zu bestimmen. Bei vereinzelt die Referenzlinie 117 durchquerenden Wolken 121 ist z. B. eine bereitstehende Batterie ausreichend. Bei dichterer Bewölkung wäre zum Beispiel die Vorbereitung einer Brennstoffzelle zum Einsatz angebracht. Bei starker Bewölkung oder bei die Sonnenstrahlung blockendem Hochnebel, der noch über Stunden anhalten kann, ist z. B. die Bereitstellung eines Zusatzkraftwerks zu organisieren.

In der Figur 4b sind dieselben Gegebenheiten zu einem späteren Stand der Sonne 105 gezeigt. Die Linie 111 wurde entsprechend an den neuen Sonnenstand angepasst. Ebenso hat der Wind leicht gedreht und weht jetzt aus einer anderen Richtung 115, wodurch der elliptische Bereich 113 zusammen mit der Referenzlinie 117 entsprechend mitgedreht wurde.

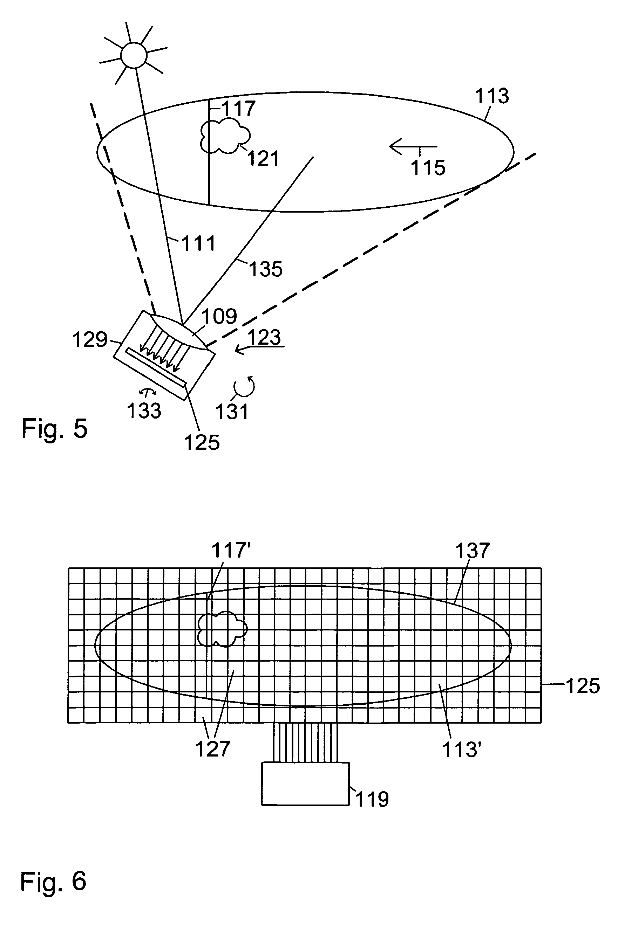

In der Figur 5 ist in der Nähe des Punktes 109 ein optisches System 123 gezeigt, welches durch eine einfache Sammellinse dargestellt ist. Hier liegt also keine Fischaugenoptik vor. Das optische System 123 sammelt die schräg einfallende Lichtstrahlung aus dem Bereich 113 ein und gibt sie als im Wesentlichen parallele Strahlung auf eine ebene Matrix 125 von Photozellen 127, vgl. Fig. 6. Das optische System 123 befindet sich zusammen mit der ortsfest an ihm angeordneten Matrix 125 in einem Gehäuse 129, welches entlang eines ersten Doppelpfeils 131 drehbar und entlang eines zweiten Doppelpfeils 133 schwenkbar gelagert ist. Dieses kann z.B. durch ein Kardan- oder Kugelgelenk realisiert sein. Dadurch wird mittels einer nicht gezeigten, dieses Gelenk steuernden Steuereinrichtung erreicht, dass das optische System 123 abhängig von der herrschenden Windrichtung 115 und dem vorliegenden Sonnenstand immer in der Lage ist, den Bereich 113 auf Wolken 121 hin zu analysieren, bevor diese die Photovoltaikanlage abschatten. Das optische System 123 ist dabei so ausgerichtet, dass seine optische Zentralachse 135 zur Mitte des Bereichs 113 weist. Entsprechend ist die Größe der Matrix 125 so gewählt, dass der gesamte Bereich 113 auf der Matrix 125 abgebildet wird.

Dies wird nochmals aus der Figur 6 deutlich, die die Matrix 125 in einer Aufsicht zeigt. Sie besteht aus einer Vielzahl der Photozellen 127, die in einem Rechteck angeordnet sind. Das Rechteck ist so bemessen, dass ein abgebildeter Bereich 113', der in der Figur 6 mit seiner äußeren Peripherielinie 137 gezeigt ist, in das Rechteck passt. Der abgebildete Bereich 113' entspricht dem durch das Linsensystem bearbeiteten Bereich 113 zwischen der Photovoltaikanlage 103 und der Sonne 105. Die Photozellen 127 sind insbesondere einzeln an die Auswerteeinheit 119 angeschlossen. Dort wird die Lage der Photozelle 127 innerhalb der Matrix mit der empfangenen Signalstärke der zugehörigen Photozelle korreliert und in Bezug gesetzt zur abgebildeten Referenzlinie 117'. Dadurch wird die Auswerteeinheit 119 in die Lage versetzt, die bei einem Wolkendurchzug zu erwartende Verminderung an Lichtintensität frühzeitig zu erkennen und eine der zuvor geschilderten Gegenmaßnahmen einzuleiten.

### Bezugszeichenliste

- Q1: erste Energiequelle
- Q2: zweite Energiequelle
- 1: Ausgangsklemmenpaar Q1
- 3: erster Schalter
- 5: erster Gleichstrommotor (Gleichstrommaschine)
- 7: Ausgangsklemmenpaar Q2
- 9: zweiter Schalter
- 11: zweiter Gleichstrommotor (Gleichstrommaschine)
- 13: Drehstromgenerator
- 15: Welle
- 17: Motorachse erster Gleichstrommotor
- 19: Motorachse zweiter Gleichstrommotor
- 21: erste Kupplung
- 23: zweite Kupplung
- 25: Anschlusselement
- 27: Brückenschalter
- 29: Batterieschalter
- 31: Batterie
- 33: Ladegerät
- 35: Ersatzkraftwerk
- 37: Zusatzschalter
- 50: Fischaugenoptik
- 52: Sonnenstrahlung
- 54: Optik
- 56: Digitalkamera
- 58: Ausgang Kamera
- 60: Eingang Vergleichseinheit
- 62: Vergleichseinheit
- 64: Ausschnitt Pixelmenge
- 66: Pixel
- 68: Analyseeinheit
- 70: Pixelgruppe
- 71: Senke
- 72: Vektor
- L: Vektorlänge
- 74: Speicherelement
- 76: Sonnenstand
- 78: Kurvenverlauf
- 80: Schwellwert
- 101: Boden
- 103: Photovoltaikanlage
- 105: Sonne
- 107: Bogen
- 109: Punkt
- 111: Linie
- 113: Bereich
- 113': abgebildeter Bereich
- 115: Pfeil
- 117: Referenzlinie
- 117': abgebildete Referenzlinie
- 119: Auswerteeinrichtung
- 121: Wolke(n)
- 123: optisches System
- 125: Matrix
- 127: Photozelle
- 129: Gehäuse
- 131: 1. Doppelpfeil
- 133: 2. Doppelpfeil
- 135: optische Zentralachse
- 137: Peripherielinie

## Patentansprüche

1. Verfahren zur Vermeidung einer drohenden Verminderung der Einspeiseleistung einer an ein Versorgungsnetz (28) angeschlossenen Photovoltaikanlage (PV1, PV2) unter einen Grenzwert aufgrund einer kommenden Abschattung durch Wolkenbildung oder Wolkenbewegung, bei dem die Bildung und/oder die Bewegung von Wolken (121) in einem vorgebbaren Bereich (113) zwischen der PV-Anlage (PV1, PV2) und einem von ihr aus einsehbaren Teil des Firmaments analysiert wird, und bei dem in Abhängigkeit des Analyseergebnisses eine Entscheidung getroffen wird, ob eine Maßnahme zur Aufrechterhaltung einer Mindesteinspeiseleistung in das Versorgungsnetz (28) zu ergreifen ist.

2. Verfahren nach Anspruch 1, **dadurch gekennzeichnet, dass** die Maßnahme die Einspeisung von Zusatzenergie, zusätzlich zu der von der PV-Anlage (PV1, PV2) erzeugten Energie mittels eines Zusatzenergielieferanten (31, 35, 39), in das Versorgungsnetz (28) ist.

3. Verfahren nach Anspruch 1 oder 2, **dadurch gekennzeichnet, dass** der vorgebbare Bereich (113) von einer Kamera (56), insbesondere einer Digitalkamera erfasst wird, dass in zeitlichen Abständen (tp, tₚ₊₁) Bilder des Bereichs (113) aufgenommen werden, die sich aus einer Vielzahl von Bildpunkten (66) zusammensetzen, dass in den Bildern der errechnete Sonnenstand berücksichtigt ist, dass aufeinande folgende Bilder miteinander verglichen werden, und dass die Veränderung der Helligkeit der Bildpunkte (66) in Bezug auf den Sonnenstand und den Standort der Kamera (56) analysiert wird.

4. Verfahren nach Anspruch 3, **dadurch gekennzeichnet, dass** die zeitlichen Abstände (tₙ, tₙ₊₁, tₙ₊₂) regelmäßig sind und direkt aufeinanderfolgende Bilder miteinander verglichen werden.

5. Verfahren nach Anspruch 3 oder 4, **dadurch gekennzeichnet, dass** eine Anzahl an zusammenhängenden Bildpunkten (66), die die gleiche oder in einem vorgebbaren Abweichungsbereich liegende Lichtintensität aufweisen, zu einer Gruppe (70) zusammengefasst werden, und dass die Wanderung dieser Gruppe (70) über den Bildbereich hin zu anderen Stellen verfolgt wird.

6. Verfahren nach Anspruch 5, **dadurch gekennzeichnet, dass** mehrere Gruppen (70) mit jeweils gleicher oder auch unterschiedlicher Lichtintensität gebildet werden, und dass jeder Gruppe ein Bewegungsvektor (72) zugeordnet wird, dessen Länge (L) der mittleren Lichtintenisität aller beteiligten Bildpunkte (66) der jeweiligen Gruppe (70) entspricht und dessen Richtung der Verschiebungsrichtung der mittleren Lichtintensität im Bild entspricht.

7. Verfahren nach einem der Ansprüche 5 oder 6, **dadurch gekennzeichnet, dass** aus den Parametern
a) räumliche Ausdehnung der Gruppe (70) und
b) ihre Wanderungsrichtung
Rückschlüsse daraufhin gezogen werden, ob und wie die Gruppe (70) eine Linie (111) zwischen dem Standort (109) der Kamera (56) und dem Stand der Sonne (105) durchquert.

8. Verfahren nach Anspruch 1 oder 2, **dadurch gekennzeichnet, dass** eine Linie (111) ausgehend von der PV-Anlage oder ihrer unmittelbaren Umgebung hin zum aktuellen Sonnenstand ermittelt wird, dass der vorgebbare Bereich (113) um diese Linie (111) herum gebildet wird, und dass der Durchzug der Wolken (121) durch diesen Bereich (113) ermittelt wird.

9. Verfahren nach Anspruch 8, **dadurch gekennzeichnet, dass** unter Berücksichtigung der herrschenden Windrichtung (115) der Bereichsrand, der in Windrichtung liegt, in die Nähe der Linie (117) gelegt wird.

10. Verfahren nach einem der Ansprüche 8 oder 9, **dadurch gekennzeichnet, dass** in den Bereich (113) eine horizontale Referenzlinie (117) gelegt wird und der Durchgang der Wolken in Bezug zu der Referenzlinie (117) analysiert wird.

11. Verfahren nach einem der Ansprüche 1 bis 6, **dadurch gekennzeichnet, dass** der Bereich (113) eine Ausdehnung zwischen 5 und 100 Quadratkilometern Wolkenbild hat.

12. Verfahren nach einem der Ansprüche 2 bis 11, **dadurch gekennzeichnet, dass** neben der Entscheidung, ob die Einspeisung zusätzlicher Energie erforderlich ist, auch die voraussichtlich benötigte Menge an Zusatzenergie ermittelt wird.

13. Vorrichtung zur Durchführung des Verfahrens nach einem der Ansprüche 3 bis 7, **gekennzeichnet durch** eine Fischaugenoptik (50), die den einsehbaren Teil des Firmaments zumindest teilweise auf die Optik einer Digitalkamera (56) zur Bildung des vorgebbaren Bereichs (113) abbildet, **durch** ein Speicherbauteil (74), in welches in zeitlichen Abständen aufgenommene Bilder des Bereichs abgelegt sind, **durch** einen Speicher (62), in den die Koordinaten des Sonnenverlaufs eingeschrieben sind, und **durch** eine Recheneinheit (68), der der zu einem Zeitpunkt vorliegende Sonnenstand zusammen mit mindestens zwei abgespeicherten Bildern zugeführt sind, und die die mindestens zwei Bilder miteinander vergleicht und die Veränderung der Helligkeit der Bildpunkte der Bilder in Bezug auf den Sonnenstand analysiert. (Fig. 2a)

14. Vorrichtung zur Durchführung des Verfahrens nach einem der Ansprüche 8 bis 12, **gekennzeichnet durch** einen Lichtdetektor 125), der eine Vielzahl von matrixartig angeordneten Photozellen (127) aufweist, und **durch** ein Analysegerät (119), das das auf die Photozellen (127) einfallende Licht auf seine Verteilung auf der Matrix und auf seine Intensität hin analysiert. (Fig. 5)
